# EUROPÄISCHE PATENTSCHRIFT

(11) **EP 2 546 837 B1**
(45) Veröffentlichungstag und Bekanntmachung des Hinweises auf die Patenterteilung: **21.12.2016**
(21) Anmeldenummer: 12002829.5
(22) Anmeldetag: 23.04.2012
(51) Int. Cl.: G11C 16/14, G06F 12/02, G06F 11/00

(54) **Verfahren zum Erkennen von gelöschten Speicherbereichen**
Method for detecting deleted storage areas
Procédé destiné à détecter des zones de stockage effacées

(30) Priorität: 15.07.2011 DE 102011107435
(43) Veröffentlichungstag der Anmeldung: 16.01.2013
(73) Patentinhaber: Giesecke & Devrient GmbH, 81677 München (DE)
(72) Erfinder: Rankl, Wolfgang, 81825 München (DE)

(56) Entgegenhaltungen:
- WO-A1-2008/045839
- US-A1- 2009 067 241
- US-A1- 2010 169 586
- US-A1- 2011 153 913

## Beschreibung

Die Erfindung betrifft ein Verfahren zur Fehleranalyse an einem in Speicherbereiche unterteilten elektronischen Speicher, insbesondere zum Erkennen von fälschlicherweise gelöschten Speicherbereichen in dem Speicher, z.B. einem in Speicherseiten (Pages) unterteilten Flash-Speicher.

Moderne Chipkarten benutzen für Betriebssystem und Daten Flash-Speicher. Flash-Speicher sind in Speicherseiten (Pages) unterteilt, die zurzeit eine typische Größe von 256 Bytes, d.h. 256*8 einzelnen Speicherzellen, haben. Die Chipkarte hat neben dem Flash-Speicher insbesondere eine Prozessor und einen Arbeitsspeicher RAM.

Jede Speicherzelle des Flash-Speichers kann zwei Speicherzustände annehmen, beschrieben und gelöscht. Ein byteweises (ggf. auch bit- oder wortweises) Ansteuern des Flash-Speichers ist nur beim Schreiben, d.h. beim Programmieren des Speichers in den beschriebenen Zustand, möglich. Beim Löschen, d.h. beim Programmieren des Flash-Speichers in den gelöschten Zustand, ist der Flash-Speicher nur seitenweise ansteuerbar.

Ein Schreibkommando, das z.B. durch ein Chipkartenbetriebssystem an den Speicher gesandt wird, wird daher im Speicher umgesetzt in zwei Programmierschritte, nämlich einen zuerst durchgeführten Löschvorgang und einen anschließenden Schreibvorgang. Beim Löschvorgang wird die gesamte Speicherseite, auf der die zu beschreibenden Speicherzellen / Bytes angeordnet sind, in einen Pufferspeicher kopiert und anschließend gelöscht. Beim Schreibvorgang werden die im Schreibkommando angegebenen Speicherzellen in den beschriebenen Speicherzustand programmiert. Bei einem atomaren Schreibvorgang, der vor allem für wichtige Speicherinhalte gewählt wird, wird als Pufferspeicher für die zu löschende Speicherseite eine andere Speicherseite im nichtflüchtigen aber langsamen Flash-Speicher verwendet. Vor allem für weniger wichtige Speicherinhalte oder zeitkritische Programmiervorgänge werden nichtatomare Schreibvorgänge gewählt, bei denen als Pufferspeicher für die zu löschende Speicherseite ein Speicherbereich im schnellen aber flüchtigen Arbeitsspeicher RAM verwendet wird.

Tritt während der Abarbeitung eines nichtatomaren Schreibkommandos für eine Speicherseite während des Löschvorgang oder danach eine Störung, z.B. Unterbrechung in der Spannungsversorgung oder Spannungsabfall, auf, bevor der im Schreibkommando enthaltene Schreibvorgang durchgeführt worden ist, ist der ursprüngliche Speicherinhalt der Speicherseite verloren, da die Pufferung der Speicherseite ja im flüchtigen Speicher erfolgte. Datenverluste in einem Speicher durch Spannungsunterbrechungen oder Spannungsabfälle unter ein zum Erhalt des Speicherinhalts erforderliches Spannungsniveau werden mitunter auch als Tearprobleme bezeichnet.

Das Fehlen des Speicherinhalts der gelöschten und nicht wiederbeschriebenen Speicherseite kann Datenverlust bedeuten oder aber auch die Funktionsfähigkeit des Speichers beeinträchtigen, insbesondere falls Teile eines im Flash-Speicher abgespeicherten Betriebssystems gelöscht wurden. Gerade in Chipkarten, wo der Flash-Speicher knapp bemessen ist, kommt es vor, dass im Flash-Speicher zum Teil auf einer einzigen Speicherseite sowohl Daten, die häufiger geändert werden, als auch Teile des Betriebssystems abgespeichert sind. Jede Datenänderung mittels eines nichtatomaren Schreibkommandos kann somit das Betriebssystem gefährden und damit nicht nur den Speicher selbst, sondern auch weitere Komponenten der Chipkarte.

Fällt das Betriebssystem einer Chipkarte mit Flash-Speicher aus, oder sind in einer solchen Chipkarte Daten nicht mehr auffindbar, kann dies andererseits die unterschiedlichsten Gründe haben. Dem Nutzer der Chipkarte wäre schon damit geholfen, könnte er verifizieren, dass die Chipkartenprobleme auf fälschlich gelöschte Speicherseiten im Flash-Speicher zurückgehen.

Ein direkter lesender Zugriff auf den Flash-Speicher einer Chipkarte von außerhalb der Chipkarte ist nach der Ausgabe der Chipkarte aus Sicherheitsgründen nicht mehr möglich. Somit ist der Flash-Speicher nicht direkt auf fälschlich gelöschte Speicherseiten hin überprüfbar.

Das Dokument US 2009/0067241 A1 aus dem Stand der Technik offenbart ein Verfahren zur Fehleranalyse an einem in Speicherbereiche unterteilten elektronischen Speicher, wobei teilweise gelöschte Speicherbereiche identifiziert werden, wobei Anzahlen von Fehlern in den Speicherbereichen ermittelt und mit einem Schwellwert für Fehler verglichen werden.

Der Erfindung liegt die Aufgabe zu Grunde, ein Verfahren zur Fehleranalyse an einem in Speicherbereiche unterteilten elektronischen Speicher, insbesondere zum Erkennen von fälschlicherweise gelöschten Speicherbereichen in dem Speicher, z.B. einem in Speicherseiten (Pages) unterteilten Flash-Speicher, zu schaffen.

Die Aufgabe wird gelöst durch ein Verfahren nach Anspruch 1. Vorteilhafte Ausgestaltungen der Erfindung sind in den abhängigen Ansprüchen angegeben.

Das Verfahren nach Anspruch 1 ist zum Erkennen von fälschlicherweise gelöschten Speicherbereichen in einem in Speicherbereiche unterteilten elektronischen Speicher eingerichtet und ist gekennzeichnet durch die Schritte
a) Ermitteln einer Soll-Anzahl von gelöschten Speicherbereichen,
b) Ermitteln einer Ist-Anzahl von gelöschten Speicherbereichen,
c) Vergleichen der Ist-Anzahl und der Soll-Anzahl miteinander, und
d) im Fall, dass die Ist-Anzahl und die Soll-Anzahl unterschiedlich sind, Erkennen, dass fälschlicherweise gelöschte Speicherbereiche existieren.

Anhand jeder erkannten Abweichung der Ist-Anzahl von gelöschten Speicherbereichen von der Soll-Anzahl von gelöschten Speicherbereichen ist er kennbar bzw. wird definiert, dass Speicherbereiche existieren müssen, die fälschlicherweise gelöscht sind.

Identifiziert ein Programmierer bei einem funktionsunfähigen oder fehlfunktionierenden Speicher solche fälschlicherweise gelöschten Speicherseiten, so kann er zumindest andere Fehlerursachen ausschließen und möglicherweise die verlorengegangenen Speicherinhalte rekonstruieren und somit den Speicher bzw. seine Speicherinhalte wieder funktionsfähig machen.

Daher ist gemäß Anspruch 1 ein Verfahren zur Fehleranalyse an einem in Speicherbereiche unterteilten elektronischen Speicher, insbesondere zum Erkennen von fälschlicherweise gelöschten Speicherbereichen in dem Speicher, geschaffen.

Wahlweise werden die Ist-Anzahl und die Soll-Anzahl - und ggf. die Identifizierungszeichen, vgl. weiter unten - an ein zur Kommunikation mit dem Speicher eingerichtetes Terminal bereitgestellt, beispielsweise bei einem Speicher in einer Chipkarte an ein Chipkartenterminal. Wahlweise wird das Vergleichen der Ist-Anzahl und der Soll-Anzahl im Terminal durchgeführt.

Wahlweise ist als Speicher ein Speicher vorgesehen, bei dem jedes Schreibkommando (Schreibbefehl) einen zuerst durchgeführten Löschvorgang und einen nachfolgenden Schreibvorgang umfasst. Wahlweise ist jeder Speicherbereich in Speicherzellen unterteilt, die wahlweise wiederum zu Bytes oder Worten innerhalb des Speicherbereichs gruppiert sind. Wahlweise kann bei einem Löschvorgang stets nur ein ganzer Speicherbereich gelöscht werden, nicht jedoch einzelne Speicherzellen, Bytes oder Worte. Wahlweise können bei einem Schreibvorgang einzelne Speicherzellen oder Bytes oder Worte beschrieben werden.

Wahlweise ist der Speicher ein Flash-Speicher und sind die Speicherbereiche Speicherseiten in dem Flash-Speicher. Der Flash-Speicher hat die im vorangehenden Absatz beschriebenen Eigenschaften.

Der Schritt b) Ermitteln einer Ist-Anzahl von gelöschten Speicherbereichen wird wahlweise durchgeführt als Zählen von Speicherbereichen mit einem Speicherinhalt entsprechend einem gelöschten Zustand des jeweiligen Speicherbereichs.

Ein typischer Löschvorgang in einem Flash-Speicher dauert vier Millisekunden und somit relativ lange. Ein typischer Schreibvorgang in einem Flash-Speicher dauert ungefähr zehn Mikrosekunden und somit relativ kurz. In den meisten Fällen ist daher nach einer Spannungsunterbrechung während eines nichtatomaren Schreibkommandos auf eine Speicherseite die Speicherseite im Flash-Speicher gelöscht, genauer fälschlicherweise gelöscht, hat also einen gelöschten Speicherzustand. Die Wahrscheinlichkeit, dass der Spannungsabbruch während des Schreibvorgangs auftritt, ist auf Grund der kurzen Zeitdauer des Schreibvorgangs gering. Somit ist auch die Wahrscheinlichkeit gering, dass nach einer Spannungsunterbrechung die Speicherseite teilweise beschrieben ist.

Der Schritt a) Ermitteln einer Soll-Anzahl von gelöschten Speicherbereichen wird wahlweise durchgeführt als Festsetzen der Soll-Anzahl von gelöschten Speicherbereichen auf Null.

Das vorstehende Ausführungsbeispiel wird anhand einer Chipkarte mit einem in Speicherseiten aufgeteilten Flash-Speicher erläutert. In Chipkarten ist in der Regel der verfügbare Flash-Speicher knapp bemessen. Daher ist der Flash-Speicher in der Regel voll und hat im intakten Zustand keine leeren Speicherseiten. Somit ist die Soll-Anzahl von gelöschten Speicherseiten im Flash-Speicher einer solchen Chipkarte Null. Ist die gemäß Schritt b) ermittelte Ist-Anzahl von gelöschten Speicherseiten ungleich Null, so bedeutet dies, dass fälschlicherweise gelöschte Speicherseiten existieren, d.h. Speicherseiten, die eigentlich beschrieben sein sollten. Für andere in Speicherbereiche unterteilte Speicher gilt das Gesagte analog.

Wahlweise wird der Schritt a) Ermitteln einer Soll-Anzahl von gelöschten Speicherbereichen durchgeführt als Ermitteln einer Anzahl von zuvor durchgeführten Löschbefehlen (Löschkommandos). Gelöschte Speicherbereiche können durch einen Löschbefehl erzeugt werden. Bei einem Löschbefehl wird ein Löschvorgang an einem Speicherbereich durchgeführt, ohne dass nachfolgend ein Schreibvorgang durchgeführt wird. Somit wird mit jedem Löschbefehl ein leerer oder gelöschter Speicherbereich erzeugt. Gibt es in dem Speicher mehr gelöschte Bereiche als Löschbefehle durchgeführt wurden, dann existieren fälschlicherweise gelöschte Speicherbereiche. Diese Variante der Erfindung ist auch für Chipkarten anwendbar, bei denen absichtlich Speicherbereiche bzw. Speicherseiten gelöscht worden sind.

Wahlweise ist jedem Speicherbereich ein Identifizierungszeichen zugeordnet, und das Verfahren umfasst den weiteren Schritt e) Ermitteln der Identifizierungszeichen der im Schritt b) ermittelten gelöschten Speicherbereiche.

Als Identifizierungszeichen können beispielsweise Nummern von Speicherbereichen vorgesehen sein, beispielsweise Seitennummern von Speicherseiten in einem Flash-Speicher.

Anhand der Identifizierungszeichen der gelöschten Speicherbereiche ist erkennbar, welche Speicherbereiche (z.B. Speicherseiten) fälschlicherweise gelöscht worden sind. Somit ist - zumindest für den Programmierer des Speichers - erkennbar, welche Speicherinhalte gelöscht worden sind. Wurden beispielsweise bestimmte Daten gelöscht, so kann der Programmierer versuchen, diese Daten erneut in den Speicher einzuprogrammieren. Wurden Programmteile oder Teile des Betriebssystems gelöscht, so ist zumindest erkennbar, dass andere Fehlerquellen höchstwahrscheinlich ausscheiden, und möglicherweise ist die Wiederherstellung des Programms oder Betriebssystems durch erneute Einprogrammierung der fälschlicherweise gelöschten Teile in den Speicher oder als Patch in einen angebunden Speicher möglich.

Wahlweise ist der Speicher zur Ansteuerung durch ein Chipkartenbetriebssystem eingerichtet, das z.B. zumindest teilweise oder aber auch ganz im Speicher abgespeichert ist, und wobei die Ist-Anzahl und die Soll-Anzahl und ggf. die Identifizierungszeichen mittels zumindest eines an den Speicher gesendeten Chipkarten-Kommandos ermittelt werden. Wahlweise werden die Chipkarten-Kommandos durch ein Chipkartenterminal gesendet. Wahlweise werden die Ist-Anzahl und die Soll-Anzahl jeweils mittels eines Zählers gezählt und wird mittels des Chipkarten-Kommandos der Zählerstand eines oder beider der Zähler ausgelesen.

Wahlweise wird als das zumindest eine Chipkarten-Kommando zumindest ein Kommando zum Auslesen der Ist-Anzahl, der Soll-Anzahl und ggf. der Identifizierungszeichen an den Speicher gesendet, und wobei in Reaktion auf das zumindest eine Chipkarten-Kommando eine Antwort mit der Ist-Anzahl (z.B. Zählerstand) und der Soll-Anzahl (z.B. Zählerstand) und ggf. dem oder den Identifizierungszeichen bereitgestellt wird. Für diese Variante der Erfindung, bei der die Ist-Anzahl, die Soll-Anzahl und ggf. das oder die Identifizierungszeichen mittels eines Lesekommandos gewonnen werden, ist die Funktionsfähigkeit des Betriebssystems, durch welches der Speicher angesteuert wird, zwingend erforderlich.

Wahlweise wird als das zumindest eine Chipkarten-Kommando ein Reset-Kommando an den Speicher gesendet (z.B. durch ein Chipkartenterminal), und wobei in Reaktion auf das Reset-Kommando (Rücksetz-Kommando) in einem Answer-To-Reset-Kommando (ATR-Kommando) die Ist-Anzahl und die Soll-Anzahl und ggf. die Identifizierungszeichen bereitgestellt werden (z.B. an das Chipkartenterminal). Diese Variante der Erfindung, bei der die Ist-Anzahl, die Soll-Anzahl und ggf. das oder die Identifizierungszeichen mittels eines Reset-Kommandos und eines daraufhin gesendeten ATR-Kommandos gewonnen werden, ist die Funktionsfähigkeit des Betriebssystems, durch welches der Speicher angesteuert wird, nicht erforderlich. Mit anderen Worten können selbst aus einem Speichersystem, z.B. einer Chipkarte mit einem Prozessor und dem Speicher, bei dem das Betriebssystem beeinträchtigt ist, die Ist-Anzahl und die Soll-Anzahl und ggf. die Identifizierungszeichen mittels der für z.B. Chipkarten standardmäßig vorgesehenen Kommandofolge Reset, Answer-To-Reset ermittelt werden. Bei Speichersystemen mit funktionsfähigem Betriebssystem für den Speicher ist die Ermittlung von Ist-Anzahl, Soll-Anzahl und ggf. Identifizierungszeichen über die Kommandofolge Reset, Answer-To-Reset natürlich ebenso möglich.

Wahlweise ist in dem Speicher ein Chipkarten-Betriebssystem, oder zumindest ein Teil davon, abgespeichert, und wobei der Speicher in ein Prozessorsystem implementiert ist. Als Prozessorsystem ist beispielsweise eine Chipkarte (Smart Card) mit Mikroprozessor und Flash-Speicher vorgesehen, oder ein funktional vergleichbar wie eine Chipkarte aufgebauter Token in beliebiger Bauform, z.B. wie bei einem Speicher-Stick oder dergleichen.

Im Folgenden wird die Erfindung an Hand von Ausführungsbeispielen und unter Bezugnahme auf die Zeichnung näher erläutert, in der zeigt:

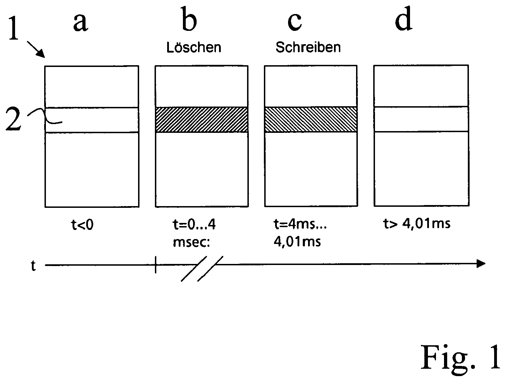

Fig. 1 einen für die Erfindung geeigneten Flash-Speicher.

Fig. 1 zeigt schematisch einen Flash-Speicher 1 mit einer Mehrzahl von Speicherseiten, von denen eine mittels eines Schreibkommandos (Schreibbefehls) zu beschreibende Speicherseite 2 hervorgehoben ist. Vor dem Eintreffen des Schreibkommandos beim Flash-Speicher 1, d.h. in einem Zeitintervall t<0, befindet sich der Flash-Speicher in einem beliebigen beschriebenen oder gelöschten Zustand, vgl. Teilfigur a. Zum Zeitpunkt t=0 geht ein Schreibkommando beim Flash-Speicher 1 ein. Im vier Millisekunden langen Zeitintervall von t=0 bis t=4ms (vier Millisekunden) wird die gesamte Speicherseite 2 gelöscht, vgl. Teilfigur b. Im 10 Mikrosekunden langen Zeitintervall von t=4ms bis t=4,01ms werden einzelne Speicherzellen der Speicherseite 2 beschrieben, entsprechend den Angaben im Schreibkommando, vgl. Teilfigur c. Nach Ablauf der 10 Mikrosekunden dauernden Schreibdauer ist der Flash-Speicher 2 in einem neu beschriebenen Zustand, vgl. Teilfigur d.

## Patentansprüche

1. Verfahren zum Erkennen von fälschlicherweise gelöschten Speicherbereichen (2) in einem in Speicherbereiche (2) unterteilten elektronischen Speicher (1), **gekennzeichnet durch** die Schritte
a) Ermitteln einer Soll-Anzahl von gelöschten Speicherbereichen (2),
b) Ermitteln einer Ist-Anzahl von gelöschten Speicherbereichen (2),
c) Vergleichen der Ist-Anzahl und der Soll-Anzahl miteinander, und
d) im Fall, dass die Ist-Anzahl und die Soll-Anzahl unterschiedlich sind, Erkennen, dass fälschlicherweise gelöschte Speicherbereiche (2) existieren.

2. Verfahren nach Anspruch 1, wobei der Speicher (1) ein Flash-Speicher ist und die Speicherbereiche (2) Speicherseiten in dem Flash-Speicher sind.

3. Verfahren nach Anspruch 1 oder 2, wobei der Schritt b) Ermitteln einer Ist-Anzahl von gelöschten Speicherbereichen (2) durchgeführt wird als Zählen von Speicherbereichen (2) mit einem Speicherinhalt entsprechend einem gelöschten Zustand des jeweiligen Speicherbereichs (2).

4. Verfahren nach einem der Ansprüche 1 bis 3, wobei der Schritt a) Ermitteln einer Soll-Anzahl von gelöschten Speicherbereichen (2) durchgeführt wird als Festsetzen der Soll-Anzahl von gelöschten Speicherbereichen (2) auf Null.

5. Verfahren nach einem der Ansprüche 1 bis 3, wobei der Schritt a) Ermitteln einer Soll-Anzahl von gelöschten Speicherbereichen (2) durchgeführt wird als Ermitteln einer Anzahl von zuvor durchgeführten Löschbefehlen.

6. Verfahren nach einem der Ansprüche 1 bis 5, wobei jedem Speicherbereich (2) ein Identifizierungszeichen zugeordnet ist, und mit dem weiteren Schritt e) Ermitteln der Identifizierungszeichen der im Schritt b) ermittelten gelöschten Speicherbereiche (2).

7. Verfahren nach einem der Ansprüche 1 bis 6, wobei der Speicher (1) zur Ansteuerung durch ein Chipkartenbetriebssystem eingerichtet ist, und wobei die Ist-Anzahl und die Soll-Anzahl und ggf. die Identifizierungszeichen mittels zumindest eines an den Speicher (1) gesendeten Chipkarten-Kommandos ermittelt werden.

8. Verfahren nach Anspruch 7, wobei als das zumindest eine Chipkarten-Kommando zumindest ein Kommando zum Auslesen der Ist-Anzahl, der Soll-Anzahl und ggf. der Identifizierungszeichen an den Speicher (1) gesendet wird, und wobei in Reaktion auf das zumindest eine Chipkarten-Kommando die Ist-Anzahl und die Soll-Anzahl und ggf. die Identifizierungszeichen bereitgestellt werden.

9. Verfahren nach Anspruch 7, wobei als das zumindest eine Chipkarten-Kommando ein Reset-Kommando an den Speicher (1) gesendet wird, und wobei in Reaktion auf das Reset-Kommando in einem Answer-To-Reset-Kommando die Ist-Anzahl und die Soll-Anzahl und ggf. die Identifizierungszeichen bereitgestellt werden.

10. Verfahren nach einem der Ansprüche 1 bis 9, wobei in dem Speicher (1) ein Chipkarten-Betriebssystem, oder zumindest ein Teil davon, abgespeichert ist, und wobei der Speicher (1) in ein Prozessorsystem, insbesondere eine Chipkarte oder ein funktional vergleichbar wie eine Chipkarte aufgebautes Token, implementiert ist, das zumindest einen Mikroprozessor und den Speicher (1) aufweist.

## Claims

1. A method of detecting erroneously erased memory areas (2) in an electronic memory (1) divided into memory areas (2), **characterized by** the steps of
a) ascertaining a target number of erased memory areas (2),
b) ascertaining an actual number of erased memory areas (2),
c) mutually comparing the actual number and the target number, and
d) in the case that the actual number and the desired number are different, detecting that there exist erroneously erased memory areas (2).

2. The method of claim 1, wherein the memory (1) is a flash memory, and the memory areas (2) are memory pages in the flash memory.

3. The method according to claim 1 or 2, wherein the step b) of ascertaining an actual number of erased memory areas (2) is carried out as a counting of memory areas (2) with a memory content corresponding to an erased state of the respective memory area (2).

4. The method according to any of the claims 1 to 3, wherein the step a) of ascertaining a target number of erased memory areas (2) is carried out as determining the target number of erased memory areas (2) to be zero.

5. The method according to any of the claims 1 to 3, wherein the step a) of ascertaining a target number of erased memory areas (2) is carried out as ascertaining a number of previously carried out erase commands.

6. The method according to any of the claims 1 to 5, wherein there is further allocated an identification mark to each memory area (2), and with the further step e) of ascertaining the identification marks of the erased memory areas (2) ascertained in step b).

7. The method according to any of the claims 1 to 6, wherein the memory (1) is adapted to be controlled by a chip card operating system, and wherein the actual number and the target number and possibly the identification marks are ascertained by means of at least one chip card command sent to the memory (1).

8. The method according to claim 7, wherein, as the at least one chip card command, at least one command for reading the actual number, the target number and possibly the identification marks is sent to the memory (1), and wherein, in response to the at least one chip card command, the actual number and the target number and possibly the identification marks are made available.

9. The method according to claim 7, wherein, as the at least one chip card command, a reset command is sent to the memory (1), and wherein, in response to the reset command, the actual number and target number and possibly the identification marks are made available in an answer-to-reset command.

10. The method according to any of the claims 1 to 9, wherein in the memory (1) a chip card operating system or at least part thereof is stored, and wherein the memory (1) is implemented in a processor system, in particular a chip card or a token structured in a functionally comparable fashion to a chip card, having at least a microprocessor and the memory (1).

## Revendications

1. Procédé de détection de zones mémoire (2) effacées par erreur dans une mémoire électronique (1) subdivisée en zones mémoire (2), **caractérisé par les** étapes
a) détermination d'un nombre prescrit de zones mémoire (2) effacées,
b) détermination d'un nombre réel de zones mémoire (2) effacées,
c) comparaison du nombre réel et du nombre prescrit l'un avec l'autre, et
d) dans le cas où le nombre réel et le nombre prescrit sont différents, détection de l'existence de zones mémoire (2) effacées par erreur.

2. Procédé selon la revendication 1, la mémoire (1) étant une mémoire flash et les zones mémoire (2) étant des pages mémoire dans la mémoire flash.

3. Procédé selon la revendication 1 ou 2, l'étape b) détermination d'un nombre réel de zones mémoire (2) effacées étant exécutée en tant que comptage de zones mémoire (2) ayant un contenu de mémoire correspondant à un état effacé de la zone mémoire (2) respective.

4. Procédé selon une des revendications de 1 à 3, l'étape a) détermination d'un nombre prescrit de zones mémoire (2) effacées étant exécutée en tant que fixation à zéro du nombre prescrit de zones mémoire (2) effacées.

5. Procédé selon une des revendications de 1 à 3, l'étape a) détermination d'un nombre prescrit de zones mémoire (2) effacées étant exécutée en tant que détermination d'un nombre d'ordres d'effacement auparavant exécutés.

6. Procédé selon une des revendications de 1 à 5, cependant que, à chaque zone mémoire (2), une marque d'identification est affectée, et comprenant l'étape e) supplémentaire de la détermination des marques d'identification des zones mémoire (2) effacées déterminées à l'étape b).

7. Procédé selon une des revendications de 1 à 6, la mémoire (1) étant configurée pour la commande par un système d'exploitation pour cartes à puce, et le nombre réel et le nombre prescrit et éventuellement les marques d'identification étant déterminés au moyen d'au moins une des instructions de carte à puce envoyées à la mémoire (1).

8. Procédé selon la revendication 7, cependant que, en tant que l'au moins une instruction de carte à puce, au moins une instruction de lecture du nombre réel, du nombre prescrit et éventuellement des marques d'identification est envoyée à la mémoire (1), et cependant que, en réaction à la au moins une instruction de carte à puce, le nombre réel et le nombre prescrit et éventuellement les marques d'identification sont mis à disposition.

9. Procédé selon la revendication 7, cependant que, en tant que l'au moins une instruction de carte à puce, une instruction de réinitialisation est envoyée à la mémoire (1), et cependant que, en réaction à l'instruction de reset, dans une instruction answer-to-reset, le nombre réel et le nombre prescrit et éventuellement les marques d'identification sont mis à disposition.

10. Procédé selon une des revendications de 1 à 9, cependant que, dans la mémoire (1), un système d'exploitation pour cartes à puce, ou au moins une partie de cela, est mémorisé(e), et cependant que la mémoire (1) est implémentée dans un système processeur, en particulier dans une carte à puce ou dans un jeton constitué de manière fonctionnellement comparable à une carte à puce, qui comporte au moins un microprocesseur et la mémoire (1).
